## Europäisches Patentamt

## European Patent Office

## Office européen des brevets

(11) Publication number: **0 136 207**
**B1**

## (12) EUROPEAN PATENT SPECIFICATION

(45) Date of publication of patent specification: **30.03.88**

(51) Int. Cl.⁴: **G 01 R 31/28**

(21) Application number: **84401610.5**

(22) Date of filing: **01.08.84**

(54) Test period generator for automatic test equipment.

(30) Priority: **01.08.83 US 518499**

(43) Date of publication of application:
**03.04.85 Bulletin 85/14**

(45) Publication of the grant of the patent:
**30.03.88 Bulletin 88/13**

(84) Designated Contracting States:
**DE FR GB IT NL**

(56) References cited:

**INTERNATIONAL TEST CONFERENCE 1983, IEEE CH1933-1/83, paper 8.5, 18th-20th October 1983, pages 200-209, IEEE, New York, USA; R.F.HERLEIN: "Optimizing the timing architecture of a digital LSI test system"**

**INTERNATIONAL TEST CONFERENCE 1983, IEEE CH1933-1/83, paper 8.3, 18th-20th October 1983, pages 188-192, IEEE, New York, USA; M. CATALANO et al.: "Individual signal path calibration for maximum timing accuracy in a high pincount VLSI test system"**

(73) Proprietor: **FAIRCHILD CAMERA & INSTRUMENT CORPORATION**
**464 Ellis Street**
**Mountain View California 94042 (US)**

(72) Inventor: **West, Burnell G.**
**46750 Sentinel Drive**
**Fremont California 94539 (US)**
Inventor: **Herlein, Richard F.**
**4237 Haines Avenue**
**San Jose California 95136 (US)**

(74) Representative: **Chareyron, Lucien et al**
**Schlumberger Limited Service Brevets c/o Giers**
**12, place des Etats Unis B.P. 121**
**F-92124 Montrouge Cédex (FR)**

(56) References cited:
**1981 INTERNATIONAL TEST CONFERENCE, IEEE CH1693-1/81, paper 7.5, 27th-29th October 1981, pages 143-153, IEEE, New York, USA; S. SUGAMORI et al.: "Analysis and definition of overall timing accuracy in VLSI test system"**

Courier Press, Leamington Spa, England.

## Description

### Background of the invention
### Field of the invention

This invention relates generally to electronic circuits used in automatic test equipment, and relates more particularly to a timing subsystem that includes several test period generators capable of supplying a variety of timing signals to a device under test.

### Description of the prior art

In automatic test equipment used for testing electronic circuits, test patterns of electronic signals are generated and applied to selected input pins of a device under test. The condition of the output pins of the device under test is then detected and compared to a desired condition to determine the functionality or quality of the circuit. The circuitry within the automatic test equipment which estalishes the timing of the test patterns is known as a timing subsystem. The timing subsystem must accurately supply timing signals to the device under test, and must be flexible enough to accommodate the timing requirements of a wide range of devices.

Prior art timing subsystems have commonly utilized constant frequency crystal oscillators to generate timing signals. The flexibility of such timing subsystems is limited since the frequencies of the timing signals are defined in terms of fixed multiples and submultiples of the fundamental oscillator frequency.

Test patterns generally include several timing signals, each having a different frequency. Commonly, major clock signals are generated to establish an overall testing rate, and minor clock signals are generated to establish higher frequency timing signals. Prior art timing subsystems using crystal oscillators have provided minor clock signals by using hardware that subdivided the major clock signals and, thus, limited the flexibility of defining the minor clock signals.

Testing requirements sometimes dictate that the timing subsystem be synchronized to the operation of the device under test so that test patterns generated by the testing system are triggered by a signal from the device under test. Prior art timing subsystems using non-resettable crystal oscillators have been inherently inaccurate in synchronizing to external events. It has been customary in such prior art automatic test equipment to pause up to one clock period after the receipt of an external synchronization signal to accommodate signal jitter. This causes a timing uncertainty on the order of one clock period.

Certain devices under test require external clock signals as timing inputs. Prior art timing subsystems typically could not easily provide an external clock signal, so standard practice has been to supply a separate crystal oscillator. This practice, however, increases the cost of testing and restricts flexibility in the operation of the automatic test equipment.

The article "Analysis and Definition of Overall Timing Accuracy in VLSI Test System" by S. Sugamori et al, 1981 International Test Conference, IEEE CH 1693-1/81, paper 7.5, 27th—29th October 1981, pages 143—153, discloses a timing apparatus comprising first and second timing generators supplying timing signals to a third timing generator. This system does not have the flexibility described above.

What is needed is an accurate, flexible, and capable timing subsystem for use in automatic test equipment.

It is a general object of the invention to provide a timing apparatus for supplying timing signals from first and second timing generators to a third timing generator.

This and other objects of the invention are attained, in accordance with one aspect of the invention by a timing apparatus comprising first and second timing generators for supplying timing signals to a third timing generator, said first timing generator being a first period generator for generating a first set of timing signals, said first set of timing signals including a first time-zero signal having edges defining a first test period and also including a first clock signal, said first clock signal commencing a first predetermined amount of time after the beginning of said first test period; said second timing generator being a second period generator for generating a second set of timing signals, said second set of timing signals including a second time-zero signal having edges defining a second test period and also including a second clock signal, said second clock signal commencing a second predetermined amount of time after the beginning of said second test period; and signal selection means coupled to said first and second period generators for supplying selected ones of said first and second sets of timing signals to said third generator.

### Brief description of the drawings

Figure 1 is a block diagram of a timing subsystem with three test period generators according to the preferred embodiment of the present invention.

Figure 2 is a schematic diagram of a major period generator and an external synchronizer circuit that are utilized in the timing subsystem of Figure 1.

Figure 3 is a timing diagram of timing signals generated by the major period generator of Figure 2.

Figure 4 is a schematic diagram of a minor period generator that is utilized in the timing subsystem of Figure 1.

Figure 5 is a schematic diagram of a free-run period generator that is utilized in the timing subsystem of Figure 1.

Figure 6 is a schematic diagram of a signal multiplexer and several timing generators that are utilized in the timing subsystem of Figure 1.

Figure 7 is a schematic diagram of a reference driver trigger delay circuit that is utilized in the timing subsystem of Figure 1.

## Detailed description of the preferred embodiment

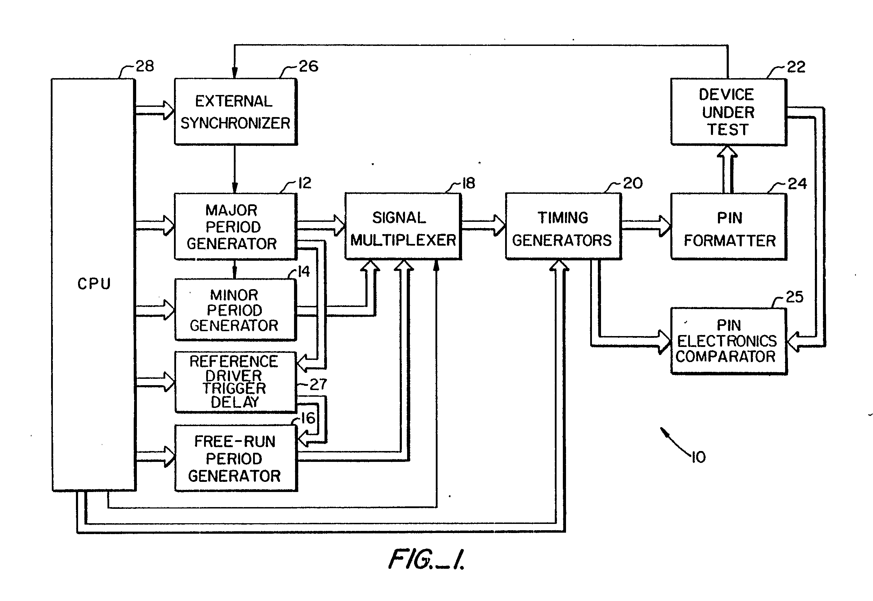

The preferred embodiment of the present invention is a timing subsystem that includes three separate period generators for supplying timing signals to a device under test. As shown in Figure 1, the three period generators of timing subsystem 10 are a major period generator 12, a minor period generator 14, and a free-run period generator 16. The major period generator generates timing signals, known as major clock signals, that define the overall testing rate. Minor period generator 14 generates minor clock signals at higher clock rates than the major clock signals. Timing signals that are independent of the major clock signals are generated by the free-run period generator. The timing signals generated by the three period generators are routed through a signal multiplexer 18 to several timing generators 20. The timing generators include both forcing timing generators and comparing timing generators. The forcing timing generators supply timing signals to a device under test 22 through a pin formatter 24, while the comparing timing generators supply timing signals to a pin electronics comparator 25. The pin electronics comparator receives output signals from the device under test and compares them to the timing signals from the comparing timing generators. A feedback loop from the device under test to the major period generator is provided by an external synchronizer circuit 26, which permits timing signals to be triggered by the device under test. A reference driver trigger delay circuit 27 is coupled to the major period generator and the free-run period generator, and provides means for calibrating the timing generators. A central processing unit 28 provides control and data management functions for the timing subsystem.

Each of the three period generators 12, 14, and 16 includes two interconnected timing interval generators. Upon the receipt of a start signal, a first timing interval generator issues a first time zero signal and a first clock signal that is aligned with respect to the first time zero signal. After a first predetermined time interval has elapsed, the first timing interval generator issues a first transfer signal that causes a second timing interval generator to issue a second time zero signal that is aligned with respect to the first transfer signal, and a second clock signal that is aligned to the second time zero signal. After a second predetermined time interval has elapsed, the second timing interval generator issues a second transfer signal that causes the first timing interval generator to issue another first time zero signal and another first clock signal. Test periods defined by the time zero signals are adjustable in duration and can overlap. The two interconnected timing interval generators of each period generator thus define alternate test periods of selectable duration and overlap.

While the circuitry and operation of the three period generators 12, 14, and 16 are quite similar in many respects, each period generator serves a unique function within timing subsystem 10.

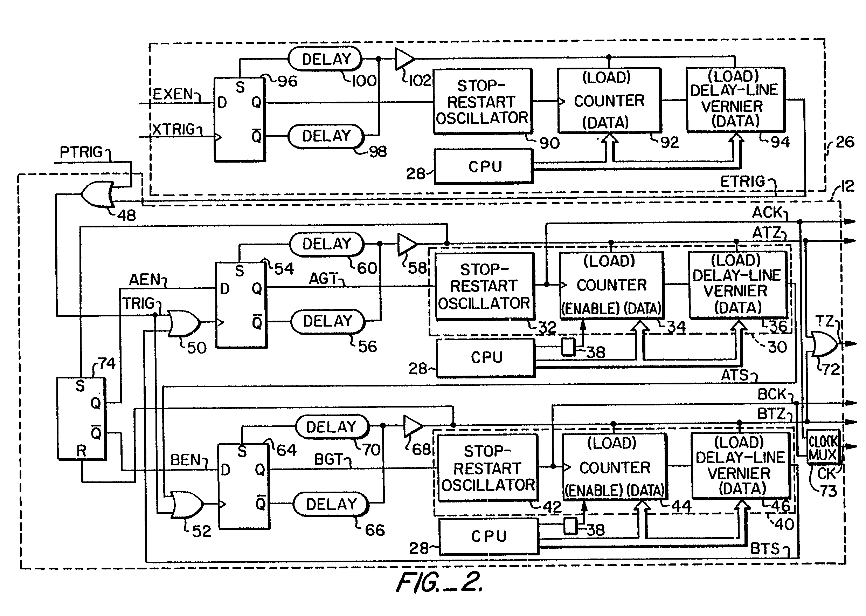

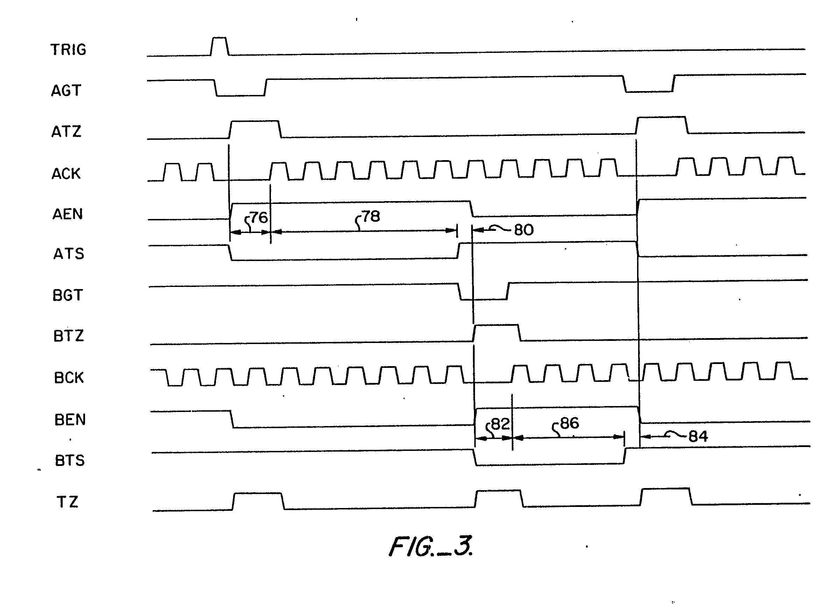

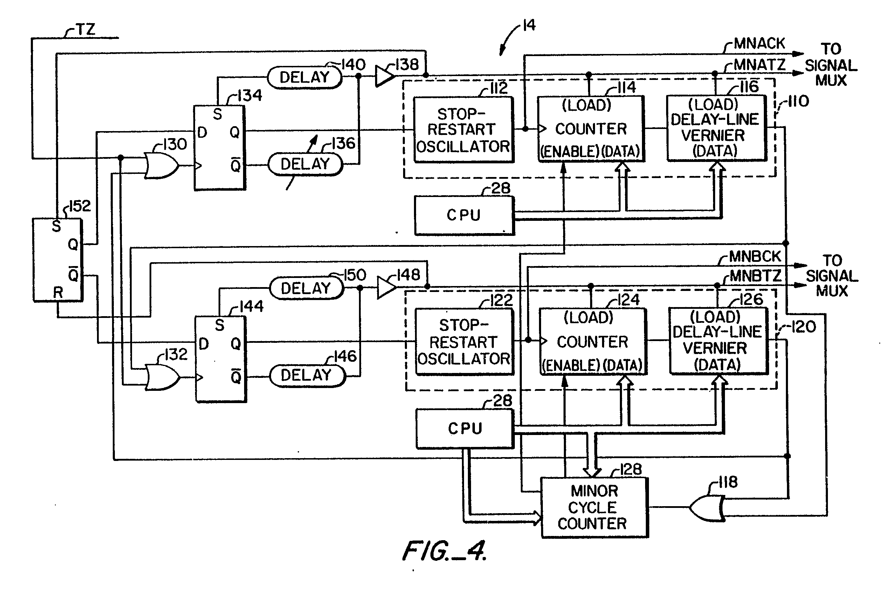

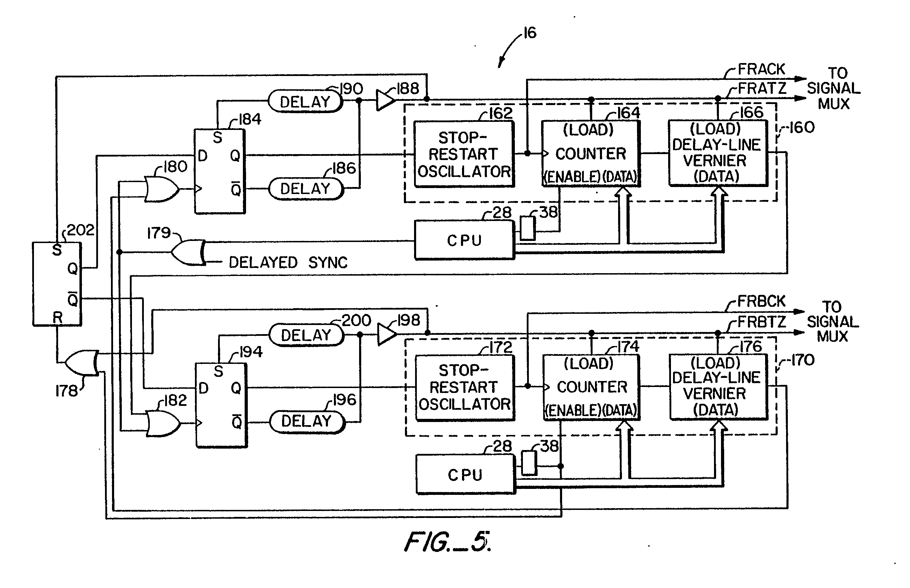

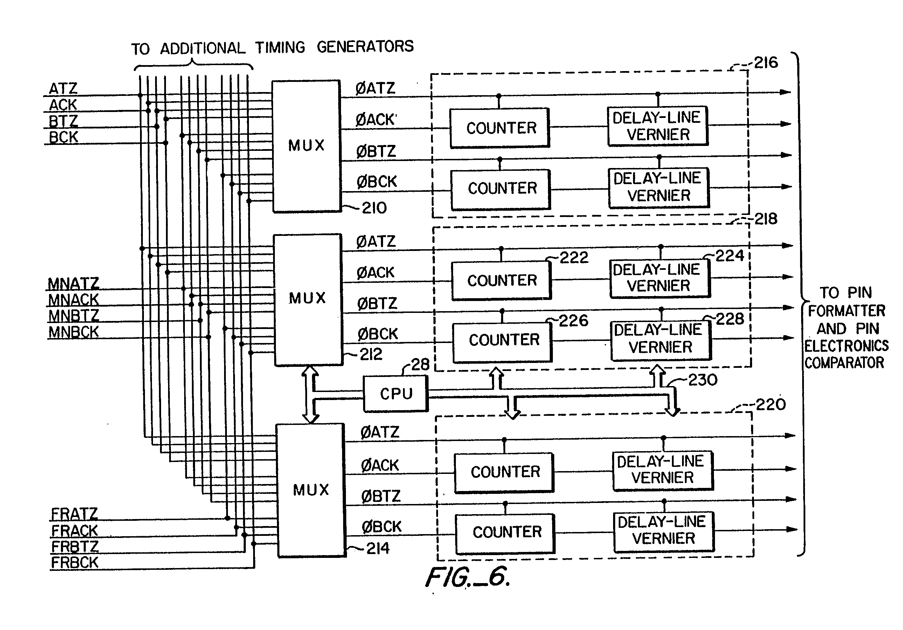

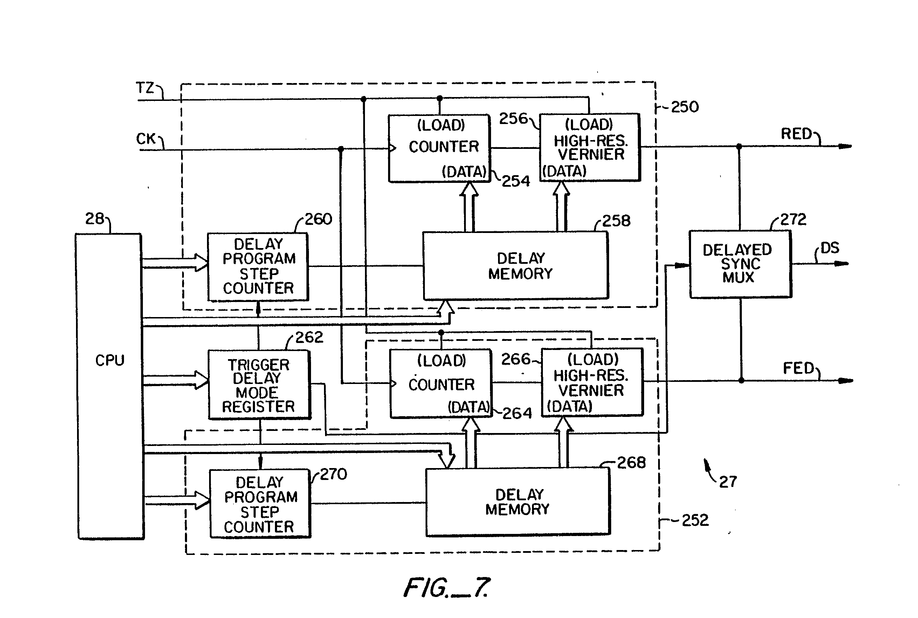

Accordingly, each of the period generators will be described separately. The major period generator 12 and the external synchronizer circuit 26 will be described in reference to Figures 2 and 3. The minor period generator 14 will be described in reference to Figure 4, and the free-run period generator 16 will be described in reference to Figure 5. Signal multiplexer 18 and timing generators 20 will be described in reference to Figure 6. The reference driver trigger delay circuit 27 will be described in reference to Figure 7.

The circuitry of the major period generator 12 is illustrated in Figure 2. A first timing interval generator 30 includes a stop-restart oscillator 32, a counter 34, and a delay-line vernier 36. Oscillator 32 generates a first clock signal, ACK, which is connected to the clock input terminal of counter 34 and is also connected to the signal multiplexer 18 for routing to the timing generators 20. Vernier 36 has an input terminal connected to an output terminal of counter 34, and generates a first transfer signal ATS. The central processing unit 28 is coupled to an input terminal of a sync mode register 38 and to data input terminals of both counter 34 and vernier 36. An output terminal of sync mode register 38 is connected to an enable input terminal of counter 34. The delay-line verniers of the present invention are preferably formed of multiplexers connected to progressive taps of delay line circuits. The selection of various delays is accomplished by the multiplexers.

Similarly, a second timing interval generator 40 includes a stop-restart oscillator 42, a counter 44, and a delay-line vernier 46. Oscillator 42 generates a second clock signal, BCK, which is connected to the clock input terminal of counter 44 and is also connected to the signal multiplexer 18 for routing to the timing generators 20. Vernier 46 has an input terminal connected to an output terminal of counter 44, and generates a second transfer signal BTS. The central processing unit 28 is coupled to data input terminals of both counter 44 and vernier 46. An output terminal of sync mode register 38 is connected to an enable input terminal of counter 44. The components of the first and second timing interval generators are matched so that both timing interval generators operate in substantially the same fashion.

The remainder of the circuitry of the major period generator 12 provides triggering means for receiving triggering signals from the central processing unit 28 and the external synchronizer circuit 26 and for alternately triggering the first and second timing interval generators 30 and 40. Either the central processing unit generates signal PTRIG, or the external synchronizer circuit generates signal ETRIG to initiate a testing sequence. An OR gate 48 receives PTRIG and ETRIG as input signals, and supplies signal TRIG to input terminals of OR gates 50 and 52. OR gate 50 also receives transfer signal BTS from vernier 46 as an input signal. The output terminal of OR gate 50 is connected to the clock input terminal of a D-type flip-flop 54. The non-inverting (Q) output terminal of flip-flop 54 generates signal AGT, which is coupled to oscillator 32 for stopping and restarting clock signal ACK. The inverting output terminal of flip-flop 54 is connected to one end of a delay line 56. The other end of delay line 56 is connected to the input terminal of a buffer 58 and to one end of another delay line 60. The other end of delay line 60 is connected to the set input terminal of flip-flop 54. Buffer 58 generates a first time zero signal, ATZ, which designates the beginning of each first phase test period defined by the first timing interval generator 30. Signal ATZ is coupled to load input terminals of counter 34 and vernier 36 for initiating the loading of data from the central processing unit. Signal ATZ is also connected to the signal multiplexer 18 for routing to the timing generators 20.

The second timing interval generator 40 is triggered through OR gate 52. OR gate 52 receives transfer signal ATS from vernier 36 and signal TRIG from OR gate 48 as its two input signals. The output terminal of OR gate 52 is connected to the clock input terminal of a D-type flip-flop 64. The non-inverting (Q) output terminal of flip-flop 64 generates signal BGT, which is coupled to oscillator 42 for stopping and restarting clock signal BCK. The inverting output terminal of flip-flop 64 is connected to one end of a delay line 66. The other end of delay line 66 is connected to the input terminal of a buffer 68 and to one end of another delay line 70. The other end of delay line 70 is connected to the set input terminal of flip-flop 64. Buffer 68 generates a second time zero signal, BTZ, which designates the beginning of each second phase test period defined by the second timing interval generator 40. Signal BTZ is coupled to load input terminals of counter 44 and vernier 46 for initiating the loading of data from the central processing unit. Signal BTZ is also connected to the signal multiplexer 18 for routing to the timing generators 20. Signals ATZ and BTZ are also supplied to input terminals of an OR gate 72, which generates signal TZ as a composite time zero signal. Signals ACK and BCK are supplied to input terminals of a clock multiplexer 73, which generates signal CK. Signal CK is equal to either signal ACK or signal BCK, depending upon which portion of the major period generator is in operation.

A flip-flop 74 enables either the first or the second timing interval generator to define the initial test period and to thereafter alternate between the two timing interval generators. Flip-flop 74 generates signal AEN at its non-inverting (Q) output terminal and supplies AEN to the D input terminal of flip-flop 54. The first timing interval generator 30 is enabled to receive a triggering input signal when signal AEN is logic low. Flip-flop 74 generates signal BEN at its inverting output terminal and supplies BEN to the D input terminal of flip-flop 64. The second timing interval generator 40 is enabled to receive a triggering input signal when signal BEN is logic low. Signal ATZ is coupled to the set input terminal of flip-flop 74, while signal BTZ is coupled to the reset input terminal of flip-flop 74.

Figure 3 illustrates the interrelationships among the various signals during the operation of the major period generator in internal sync mode. When the timing subsystem operates in internal sync mode, the sync mode register 38 enables counters 34 and 44. In Figure 3, time increases from left to right. Signal TRIG is at a logic low state until a positive pulse initiates the initial test period. The positive-going edge of TRIG passes through OR gate 50 and into the clock terminal of flip-flop 54. Assuming that signal AEN is logic low (enabling the first timing interval generator), the positive-going edge of TRIG causes signal AGT to go to the logic low state. A logic low state for signal AGT stops the clock pulses of the first clock signal ACK. The positive-going pulse from the inverting input of flip-flop 54 is delayed by delay line 56, and then emerges from buffer 58 as a positive edge in signal ATZ. The positive edge of signal ATZ loads data into counter 34 and vernier 36, resets transfer signal ATS to logic low, and activates the set input terminal of flip-flop 74. Flip-flop 74 responds by setting signal AEN to logic high and signal BEN to logic low. The positive edge of signal ATZ also causes a positive edge in signal TZ.

The positive edge of ATZ designates the beginning of the initial test period. The positive edge from delay line 56 is further delayed by delay line 60, and then activates the set input terminal of flip-flop 54. When this happens, signal AGT returns to logic high, causing the oscillator 32 to restart. Since the delays through delay lines 56 and 60 and flip-flop 54 are constant, clock signal ACK is precisely aligned with respect to the time zero signal, ATZ. The known delay from the positive edge of ATZ to the restarting of ACK is shown as time interval 76 in Figure 3. Signal ATZ returns to the logic low state after the negative edge from the inverting output terminal of flip-flop 54 propagates through delay line 56 and buffer 58. Signal ATZ remains at the logic low state and signal ACK continues to generate clock pulses until the beginning of the next first phase test period.

After a predetermined time interval has passed subsequent to the beginning of the first phase test period, a second phase test period is begun. The duration of this predetermined time interval is determined by the data loaded into counter 34 and vernier 36 from the central processing unit. When the first clock signal ACK restarts, counter 34 starts counting clock pulses. After a preselected number of clock pulses have been counted, counter 34 supplies a signal to the delay-line vernier 36. Vernier 36 delays this signal by an amount equal to a preselected delay, and then switches the first transfer signal, ATS, to logic high. The positive edge of signal ATS propagates through OR gate 52 and into the clock terminal of flip-flop 64. Flip-flop 64 switches signal BGT to the logic low state, which in turn causes the second clock signal, BCK, to stop. The second time zero signal, BTZ, goes positive a short time later, after propagating through delay line 66 and buffer 68. The positive edge of BTZ designates the beginning of the second phase test period. The positive edge of signal BTZ loads data into counter 44 and vernier 46, resets transfer signal BTS to logic low, and activates the reset input terminal of flip-flop 74. Flip-flop 74 responds by setting signal AEN to logic low and signal BEN to logic high. The positive edge of signal BTZ also causes a positive edge in signal TZ.

The positive edge of BTZ designates the beginning of the second phase test period. The positive edge of the signal emerging from delay line 66 is further delayed by delay line 70, and then activates the set input terminal of flip-flop 64. When this happens, signal BGT returns to logic high, causing the oscillator 42 to restart. Since the delays through delay lines 66 and 70 and flip-flop 64 are constant, clock signal BCK is precisely aligned with respect to the time zero signal, BTZ. The known delay from the positive edge of BTZ to the restarting of BCK is shown as time interval 82 in Figure 3. Signal BTZ returns to the logic low state after the negative edge from the inverting output terminal of flip-flop 64 propagates through delay line 66 and buffer 68. Signal BTZ remains at the logic low state and signal BCK continues to generate clock pulses until the beginning of the next second phase test period.

After another predetermined time interval has passed subsequent to the beginning of the second phase test period, the initial first phase test period is ended and another first phase test period is begun. The duration of this time interval is determined by the data that was loaded into counter 44 and vernier 46 from the central processing unit. When the second clock signal BCK restarts, counter 44 starts counting clock pulses. After a preselected number of pulses have been counted, counter 44 supplies a signal to the delay-line vernier 46. Vernier 46 delays this signal by an amount equal to a preselected delay, and then switches the second transfer signal, BTS, to logic high. The positive edge of signal BTS propagates through OR gate 50 and into the clock terminal of flip-flop 54. Flip-flop 54 switches signal AGT to the logic low state, which in turn causes the first clock signal, ACK, to stop. The first time zero signal, ATZ, goes positive a short time later, after propagating through delay line 56 and buffer 58. The positive edge of ATZ designates the end of the initial first phase test period and the beginning of the next first phase test period. The positive edge of signal ATZ loads new data into counter 34 and vernier 36, resets transfer signal ATS to logic low, and activates the set input terminal of flip-flop 74. The positive edge of signal ATZ also causes a positive edge in signal TZ.

The time interval between the positive edge of signal ATZ and the positive edge of signal BTZ is the sum of two fixed delays and one selectable delay. As described above, time interval 76 from the positive edge of signal ATZ to the restarting of clock signal ACK is fixed by the delays through delay line 60 and flip-flop 54. Time interval 78 spans the time period from the restarting of clock signal ACK until the generation of the positive edge of transfer signal ATS. Time interval 78 is equal to the preselected number loaded into counter 34 multiplied by the clock period of signal ACK, and added to the preselected delay loaded into vernier 36. Thus, time interval 78 is a selectable delay and is determined by the data supplied to counter 34 and vernier 36 by the central processing unit. A second fixed delay, time interval 80, is determined by propagation delays through OR gate 52, flip-flop 64, delay line 66, and buffer 68. The sum of time intervals 76, 78, and 80 equals the time interval between the positive edge of signal ATZ and the positive edge of signal BTZ.

Similarly, the time interval between the positive edge of signal BTZ and the next positive edge of signal ATZ is also the sum of two fixed delays and one selectable delay. Time interval 82 is a fixed delay through delay line 70 and flip-flop 64, while time interval 84 is a fixed delay through OR gate 50, flip-flop 54, delay line 56 and buffer 58. Time interval 86 is a selectable delay, and is determined by data supplied by the central processing unit to counter 44 and vernier 46. The sum of time intervals 76, 78, 80, 82, 84, and 86 equals the duration of the first phase test period as defined by the time interval between positive edges of signal ATZ. The duration of each of the first and second phase test periods is thus determined by two selectable delays plus fixed delays. In addition, the relative timing between each of the first and second phase test periods is determined by one selectable delay plus fixed delays.

Returning now to Figure 2, the external synchronizer circuit 26 and its connection to the major period generator are shown. The external synchronizer circuit includes another timing interval generator that comprises a stop-restart oscillator 90, a counter 92, and a delay-line vernier 94. Oscillator 90 generates a first clock signal which is connected to the clock input terminal of counter 92. Vernier 94 has an input terminal connected to an output terminal of counter 92, and generates the trigger signal ETRIG. The central processing unit 28 is coupled to data input terminals of both counter 92 and vernier 94.

The external synchronizer circuit also includes a triggering circuit that comprises a D-type flip-flop 96, two delay lines 98 and 100, and a buffer 102. The non-inverting output terminal of flip-flop 96 is connected to an input terminal of oscillator 90 for stopping and restarting the oscillator. One end of delay line 98 is connected to the inverting output terminal of flip-flop 96, and the other end is connected to the input terminal of buffer 102 and to one end of delay line 100. The other end of delay line 100 is connected to the set input terminal of flip-flop 96. Two signals are input to flip-flop 96; EXEN is an enable signal and is applied to the D input terminal, and XTRIG is a trigger signal from the device under test and is applied to the clock terminal.

The external synchronizer circuit 26 provides a feedback loop from the device under test to the major period generator 12 when the timing subsystem operates in external sync mode. The external synchronizer circuit operates as does each half of the major period generator described above, and generates ETRIG after a selected time delay subsequent to the receipt of signal XTRIG. The external synchronizer circuit is enabled by a logic low state of signal EXEN. Upon the receipt of a positive edge of signal XTRIG, the non-inverting output of flip-flop 96 stops the oscillator. After propagating through delay line 98 and buffer 102, the counter is loaded with a preselected number and the vernier is loaded with a preselected delay. After an additional delay through delay line 100, the oscillator restarts. After the counter counts up to the preselected number and the vernier delays by the preselected delay, ETRIG is generated. ETRIG triggers the generation of one time zero signal and the alignment of its corresponding clock signal. In external sync mode, the sync mode register 38 disables counters 34 and 44, thus preventing the generation of a transfer signal to trigger the operation of the other timing interval generator.

The circuitry of the minor period generator 14 is illustrated in Figure 4, and is quite similar to that of the major period generator 12. A first timing interval generator 110 includes a stop-restart oscillator 112, a counter 114, and a delay-line vernier 116. Oscillator 112 generates a minor first clock signal, MNACK, which is connected to the clock input terminal of counter 114 and is also connected to the signal multiplexer 18 for routing to the timing generators 20. Vernier 116 has an input terminal connected to an output terminal of counter 114. The central processing unit 28 is coupled to data input terminals of both counter 114 and vernier 116.

Similarly, a second timing interval generator 120 includes a stop-restart oscillator 122, a counter 124, and a delay-line vernier 126. Oscillator 122 generates a minor second clock signal, MNBCK, which is connected to the clock input terminal of counter 124 and is also connected to the signal multiplexer 18 for routing to the timing generators 20. Vernier 126 has an input terminal connected to an output terminal of counter 124. The central processing unit 28 is coupled to data input terminals of both counter 124 and vernier 126. The components of the first and second timing interval generators 110 and 120 are matched so that both timing interval generators operate in substantially the same fashion. The output terminals of both verniers 116 and 126 are connected to input terminals of an OR gate 118. A minor cycle counter 128 receives the output of OR gate 118 as an input signal, and generates output signals that are coupled to the enable inputs of counters 114 and 124. The central processing unit is also coupled to a data input terminal of the minor cycle counter.

The remainder of the circuitry of the minor period generator 14 provides triggering means for receiving triggering signals from the major period generator 12 and for alternately triggering the first and second timing interval generators 110 and 120. Signal TZ from the major period generator is coupled to input terminals of OR gates 130 and 132. OR gate 130 also receives the output signal from vernier 126 as an input signal. The output terminal of OR gate 130 is connected to the clock input terminal of a D-type flip-flop 134. The non-inverting (Q) output terminal of flip-flop 134 generates a signal which is coupled to oscillator 112 for stopping and restarting clock signal MNACK. The inverting output terminal of flip-flop 134 is connected to one end of a variable delay line 136. The other end of delay line 136 is connected to the input terminal of a buffer 138 and to one end of another delay line 140. The other end of delay line 140 is connected to the set input terminal of flip-flop 134. Buffer 138 generates a signal, MNATZ, that is a minor first time zero signal that designates the beginning of each minor first phase test period. Signal MNATZ is coupled to load input terminals of counter 114 and vernier 116 for initiating the loading of data from the central processing unit. Signal MNATZ is also connected to the signal multiplexer 18 for routing to the timing generators 20.

The second timing interval generator 120 is triggered through OR gate 132. OR gate 132 receives the output signal from vernier 116 and signal TZ as two input signals. The output terminal of OR gate 132 is connected to the clock input terminal of a D-type flip-flop 144. The non-inverting (Q) output terminal of flip-flop 144 generates a signal which is coupled to oscillator 122 for stopping and restarting clock signal MNBCK. The inverting output terminal of flip-flop 144 is connected to one end of a delay line 146. The other end of delay line 146 is connected to the input terminal of a buffer 148 and to one end of another delay line 150. The other end of delay line 150 is connected to the set input terminal of flip-flop 144. Buffer 148 generates a signal, MNBTZ, that is a minor second time zero signal that designates the beginning of each minor second phase test period. Signal MNBTZ is coupled to load input terminals of counter 124 and vernier 126 for initiating the loading of data from the central processing unit. Signal MNBTZ is also connected to the signal multiplexer 18 for routing to the timing generators 20.

A flip-flop 152 enables either the first or the second timing interval generator, 110 or 120, to define the initial minor test period and to thereafter alternate between the two timing interval generators. The non-inverting (Q) output terminal of flip-flop 152 is connected to the D input terminal of flip-flop 134. The inverting output terminal of flip-flop 152 is connected to the D input terminal of flip-flop 144. Signal MNATZ is coupled to the set input terminal of flip-flop 152, while signal MNBTZ is coupled to the reset input terminal of flip-flop 152. When the non-inverting output terminal of flip-flop 152 is at a logic low state, the first timing interval generator 110 is enabled to receive a triggering input signal. Conversely, when the inverting output terminal of flip-flop 152 is at a logic low state, the second timing interval generator 120 is enabled to receive a triggering input signal.

The minor period generator operates basically in the same manner as the major period generator, with a few differences. Since the minor period generator is defining minor test signals within a period of a major test signal, it follows that the periods of the minor test signals are shorter in duration. This is accommodated by loading smaller preselected numbers into counters 114 and 124. Another difference is that the minor cycle counter counts each minor cycle, and disables counters 114 and 124 after a preselected number of minor cycles have occurred. Still another difference is that the variable delay line 136 is included to provide means to precisely balance the fixed delay times of timing interval generators 110 and 120.

The circuitry of the free-run period generator 16 is illustrated in Figure 5, and is quite similar to that of both the major and minor period generators. The free run period generator includes two interconnected timing interval generators, plus switching and triggering means. A first timing interval generator 160 includes a stop-restart oscillator 162, a counter 164, and a delay-line vernier 166. Oscillator 162 generates a free-run first clock signal, FRACK, which is connected to the clock input terminal of counter 164 and is also connected to the signal multiplexer 18 for routing to the timing generators 20. Vernier 166 has an input terminal connected to an output terminal of counter 164. The central processing unit 28 is coupled to data input terminals of both counter 164 and vernier 166. An output terminal of the sync mode register 38 is connected to an enable input terminal of counter 164.

Similarly, a second timing interval generator 170 includes a stop-restart oscillator 172, a counter 174, and a delay-line vernier 176. Oscillator 172 generates a free-run second clock signal, FRBCK, which is connected to the clock input terminal of counter 174 and is also connected to lhe signal multiplexer 18 for routing to the timing generators 20. Vernier 176 has an input terminal connected to an output terminal of counter 174. The central processing unit 28 is coupled to data input terminals of both counter 174 and vernier 176. An output terminal of the sync mode register 38 is connected to an enable input terminal of counter 174, and is also connected to an input terminal of an OR gate 178. The components of the first and second timing interval generators 160 and 170 are matched so that both timing interval generators operate in substantially the same fashion.

The remainder of the circuitry of the free-run period generator 16 provides switching and triggering means for receiving triggering signals from the central processing unit 28 to initiate the generation of timing signals and for alternately triggering the first and second timing interval generators 160 and 170. The central processing unit is coupled to an input terminal of an OR gate 179. Another input terminal of OR gate 179 receives a delayed sync signal, DS, from the reference driver trigger delay circuit 27 (see Figure 7), while an output terminal thereof is connected to input terminals of OR gates 180 and 182. OR gate 180 also receives the output signal from vernier 176 as an input signal. The output terminal of OR gate 180 is connected to the clock input terminal of a D-type flip-flop 184. The non-inverting (Q) output terminal of flip-flop 184 generates a signal which is coupled to oscillator 162 for stopping and restarting clock signal FRACK. The inverting output terminal of flip-flop 184 is connected to one end of a delay line 186. The other end of delay line 186 is connected to the input terminal of a buffer 188 and to one end of another delay line 190. The other end of delay line 190 is connected to the set input terminal of flip-flop 184. Buffer 188 generates a signal, FRATZ, that is a free-run first time zero signal that designates the beginning of each free-run first phase test period. Signal FRATZ is coupled to load input terminals of counter 164 and vernier 166 for initiating the loading of data from the central processing unit. Signal FRATZ is also connected to the signal multiplexer 18 for routing to the timing generators 20.

The second timing interval generator 170 is triggered through OR gate 182. OR gate 182 receives input signals from the central processing unit 28 and vernier 166. The output terminal of OR gate 182 is connected to the clock input terminal of a D-type flip-flop 194. The non-inverting (Q) output terminal of flip-flop 194 generates a signal which is coupled to oscillator 172 for stopping and restarting clock signal FRBCK. The inverting output terminal of flip-flop 194 is connected to one end of a delay line 196. The other end of delay line 196 is connected to the input terminal of a buffer 198 and to one end of another delay line 200. The other end of delay line 200 is connected to the set input terminal of flip-flop 194. Buffer 198 generates a signal, FRBTZ, that is a free-run second time zero signal that designates the beginning of each free-run second phase test period. Signal FRBTZ is coupled to load input terminals of counter 174 and vernier 176 for initiating the loading of data from the central processing unit. Signal FRBTZ is also connected to the signal multiplexer 18 for routing to the timing generators 20.

A flip-flop 202 enables either the first or the second timing interval generator, 160 or 170, to define the initial free-run test period and to thereafter alternate between the two timing interval generators when the timing subsystem is in external sync mode. The non-inverting (Q) output terminal of flip-flop 202 is connected to the D input terminal of flip-flop 184. The inverting output terminal of flip-flop 202 is connected to the D input terminal of flip-flop 194. Signal FRATZ is supplied to the set input terminal of flip-flop 202. Signal FRBTZ is supplied to an input terminal of OR gate 178. The output terminal of OR gate 178 is connected to the reset input terminal of flip-flop 202. When the non-inverting output terminal of flip-flop 202 is at a logic low state, the first timing interval generator 160 is enabled to receive a triggering input signal. Conversely, when the inverting output terminal of flip-flop 202 is at a logic low state, the second timing interval generator 170 is enabled to receive a triggering input signal.

The free-run period generator 16 operates independently of the other two period generators. When the timing subsystem is in internal sync mode, the sync mode register 38 enables counters 34 and 44 to enable the major period generator 12, and disables counters 164 and 174 to disable the free-run period generator. In external sync mode, however, the major period generator is disabled and the free-run period generator is enabled. In external sync mode, the free-run period generator generates timing signals that are supplied to the device under test 22, and the major period generator generates one time-zero signal and an aligned clock signal in response to a signal that is fed back from the device under test to the major period generator through the external synchronizer circuit 26.

Figure 6 illustrates the circuitry of a portion of the signal multiplexer 18 and three timing generators 20. Additional timing generators may be included, but are not shown. The purpose of the signal multiplexer is to selectively connect the time zero and clock signals from the three period generators 12, 14, and 16 to the several timing generators. Each multiplexer 210, 212, and 214 selectively connects one of the three groups of time zero and clock signals to its associated timing generator 216, 218, and 220, respectively. Each multiplexer has twelve input terminals that are coupled to signals ATZ, ACK, BTZ, BCK, MNATZ, MNACK, MNBTZ, MNBCK, FRATZ, FRACK, FRBTZ, and FRBCK. Each multiplexer also has four output terminals that define signals ØATZ, ØACK, ØBTZ, and ØBCK. Output signal ØATZ, for example, is equal to either ATZ, MNATZ, or FRATZ, depending upon the selection by the multiplexer. The selection of each multiplexer is controlled by the central processing unit 28.

Each function generator includes two pairs of counters and delay-line verniers. Counter 222 and vernier 224 form a ØA pair, and counter 226 and vernier 228 form a ØB pair. A clock input terminal of counter 222 is coupled to signal ØACK, a load input terminal of counter 222 is coupled to signal ØATZ, a data input terminal of counter 222 is coupled to data bus 230 of the central processing unit 28, and an output terminal of counter 222 is coupled to vernier 224. Vernier 224 has a load input terminal coupled to receive signal ØATZ, and an output terminal coupled to the pin formatter 24. A clock input terminal of counter 226 is coupled to signal ØBCK, a load input terminal of counter 226 is coupled to signal ØBTZ, a data input terminal of counter 226 is coupled to data bus 230 of the central processing unit 28, and an output terminal of counter 226 is coupled to vernier 228. Vernier 228 has a load input terminal coupled to receive signal ØBTZ, and an output terminal coupled to the pin formatter 24.

Each counter-vernier pair operates to define time intervals in the same way as do the counter-vernier pairs of the period generators. The major difference is that the function generators are slave units that utilize the oscillators of the period generators for clock signals and the associated time zero signals as data load signals. The two counter-vernier pairs within each function generator alternate to define overlapping test periods. The time zero signal that is applied to the counter and vernier of the function generator loads data from the data bus to define a preselected delay. The counter counts clock periods up to a preselected number, and then the delay-line vernier delays the resulting signal by a preselected delay. In essence, the signal multiplexer 18 and timing generators 20 provide broad flexibility in defining timing signals for the device under test.

Figure 7 illustrates the circuitry of the reference driver trigger delay circuit 27. Two parallel channels 250 and 252 are provided, one for the generation of a rising edge delay signal, RED, and the other for the generation of a falling edge delay signal, FED. The rising edge channel 250 includes a delay counter 254, a high-resolution vernier 256, a delay memory 258, and a delay program step counter 260. Clock signal CK is applied to a clock input terminal of counter 254, while time-zero signal TZ is applied to load input terminals of both counter 254 and vernier 256. An input terminal of vernier 256 is connected to an output terminal of counter 254. An output terminal of vernier 256 generates the rising edge delay signal RED. Delay memory 258 is coupled to both counter 254 and vernier 256 for supplying data to define the duration of the delay through channel 250. The delay memory receives the data from the central processing unit 28. It contains a plurality of entries, with each entry defining a separate delay time. Counter 260 serves as an address pointer to indicate which entry in the delay memory is to be loaded into the counter and vernier. Counter 260 has the capability of incrementing its address pointer by one address upon each timing cycle. A trigger delay mode register 262 is coupled to counter 260 for selecting its mode of operation.

Similarly, the falling edge channel 252 includes a delay counter 264, a high-resolution vernier 266, a delay memory 268, and a delay program step counter 270. Clock signal CK is applied to a clock input terminal of counter 264, while time-zero signal TZ is applied to load input terminals of both counter 264 and vernier 266. An input terminal of vernier 266 is connected to an output terminal of counter 264. An output terminal of vernier 266 generates the falling edge delay signal FED. Delay memory 268 is coupled to both counter 264 and vernier 266 for supplying data to define the duration of the delay through channel 252. The delay memory receives the data from the central processing unit 28. It contains a plurality of entries, with each entry defining a separate delay time. Counter 270 serves as an address pointer to indicate which entry in the delay memory is to be loaded into the counter and vernier. Counter 270 has the capability of incrementing its address pointer by one address upon each timing cycle. The trigger delay mode register 262 is also coupled to counter 270 for selecting its mode of operation.

Counter 254 and vernier 256, and counter 264 and vernier 266 form slave units, similar to those of the timing generators. Verniers 256 and 266 are, however, high-resolution verniers that preferably incorporate linear ramps and comparators to provide a high degree of precision. Each counter and vernier pair is triggered by signal TZ, and each generates an output pulse after a programmed delay subsequent to the receipt of a triggering pulse. Signals RED and FED are supplied to a delayed sync multiplexer 272, which generates a delayed sync signal, DS, equal to either RED or FED.

In general, the reference driver trigger delay circuit provides reference signals for use in system calibration. One operational mode of the reference driver trigger delay circuit is used for calibration of the timing generators 20. In this operational mode, the reference driver trigger delay circuit operates in conjunction with the major period generator and the free-run period generator to calibrate the forcing and comparing timing generators. Both a forcing timing signal and a comparing timing signal are initiated by signals TZ and CK generated by the major period generator. The forcing timing signal is initiated directly by signals TZ and CK, and is routed through the pin formatter 24, to the device under test 22, to the pin electronics comparator 25.

The comparing timing signal is initiated indirectly by signals TZ and CK. The reference driver trigger delay circuit issues the delayed sync signal DS after a programmed delay subsequent to the receipt of a pulse of signal TZ. Signal DS may equal either the rising edge delay signal RED or the falling edge delay signal FED, depending upon the selection of multiplexer 272. Signal DS triggers the free-run period generator to stop and restart oscillator 162 (Figure 5) to generate free-run clock signal FRACK, and to issue free-run time-zero signal FRATZ. The sync mode register is set for operation in internal sync mode. This disables the free-run counters 164 and 174, and continually resets flip-flop 202. As a result, signal DS always triggers oscillator 162, not oscillator 172. Signals FRACK and FRATZ then trigger a comparing timing generator to generate the comparing timing signal. This signal is then supplied to the pin electronics comparator for comparison to the forcing timing signal received from the device under test.

One feature of the reference driver trigger delay circuit is particularly advantageous in calibrating the timing generators. Recall that the delay memory contains a plurality of entries, each defining a separate delay time, and that the delay program step counter, can address a succession of delay times in a succession of timing cycles. If a series of delay times, each successively slightly longer or shorter in duration, is loaded into the delay memory, then a series of comparing timing signals, each slightly skewed with respect to the forcing timing signal, will be generated over a succession of timing cycles. By bracketing the forcing timing signal, its timing relative to the comparing timing signals can be accurately determined.

## Claims

1. A timing apparatus comprising first and second timing generators for supplying timing signals to a third timing generator characterized by

said first timing generator being a first period generator (12) for generating a first set of timing signals, said first set of timing signals including a first time-zero signal having edges defining a first test period and also including a first clock signal, said first clock signal commencing a first predetermined amount of time after the beginning of said first test period;

said second timing generator being a second period generator (14) for generating a second set of timing signals, said second set of timing signals including a second time-zero signal having edges defining a second test period and also including a second clock signal, said second clock signal commencing a second predetermined amount of time after the beginning of said second test period; and

signal selection means (18) coupled to said first and second period generators for supplying selected ones of said first and second sets of timing signals to said third generator (20).

2. The timing apparatus according to claim 1, characterized in that said first and second time-zero signals are variable to vary said first and second test periods.

3. The timing apparatus according to claim 1 or 2, characterized in that said first (12) and second (14) period generators are major and minor period generators, respectively, said second period generator is coupled to said first period generator, said second test period is within said first test period, and said second test period commences a third predetermined amount of time after said beginning of said first test period.

4. The timing apparatus according to claim 3, characterized by a free-run period generator (16) for generating a third set of timing signals, said third set of timing signals including a free-run time-zero signal having edges defining a free-run test period, and also including a free-run clock signal, said free-run clock signal commencing a third predetermined amount of time after a beginning of said free-run test period, said free-run time-zero signal being variable to vary said free-run test period.

5. The timing apparatus according to claim 4, characterized in that said third set of timing signals further includes a second free-run time-zero signal and second free-run clock signal, said free-run period generator (16) including a first

9

free-run timing interval generator (160) for producing said first mentioned free-run time-zero and clock signals and a first free-run transfer signal, and a second free-run timing interval generator (170) for producing said second free-run time-zero and clock signals and a second free-run transfer signal, said second free-run timing interval generator (170) being triggered by said first free-run transfer signal to produce said second free-run time-zero and clock signals, and said first free-run timing interval generator (160) being triggered by said second free-run transfer signal to produce said first free-run time-zero and clock signals.

6. The timing apparatus according to any one of claims 3—5, characterized by programmable delay means (130, 132, 134, 136, 140, 144, 146, 150), coupled to receive said first time-zero and clock signals for generating a delayed sync signal after a programmable delay subsequent to the receipt of said first time-zero signal, said second period generator (14) being coupled to said programmable delay means (130, 132, 134, 136, 140, 144, 146, 150) and being adapted to generate said second time-zero signal a fixed delay after receipt of said delayed sync signal.

7. The timing apparatus according to claim 6, characterized in that said third timing generator (20) is a slave timing generator which includes first (222) and second (226) test timing generators for generating first and second test timing signals after first (224) and second (228) delays subsequent to the receipt of said first and second time-zero signals, respectively, and wherein the difference between said first delay and the sum of said programmable delay, said fixed delay and said second delay is a measure of calibration error for said first and second timing generators.

8. The timing apparatus according to any one of the previous claims, characterized in that said first set of timing signals further includes a third time-zero signal and third clock signal, said first period generator (12) including a first timing interval generator (30) for producing said first time-zero and clock signals and a first transfer signal and a third timing interval generator (40) for producing said third time-zero and clock signals and a third transfer signal, said third timing interval generator (40) being triggered by said first transfer signal to produce said third time-zero and clock signals and said first timing interval generator being triggered by said third transfer signal to produce said first time-zero and clock signals.

9. The timing apparatus according to claim 8, characterized in that said second set of timing signals further includes a fourth time-zero signal and fourth clock signal, said second period generator (14) including a second timing interval generator (110) for producing said second time-zero and clock signals and a second transfer signal and a fourth timing interval generator (120) for producing said fourth time-zero and clock signals and a fourth transfer signal, said fourth timing interval generator being triggered by said second transfer signal to produce said fourth time-zero and clock signals, and said second timing interval generator being triggered by said fourth transfer signal to produce said second time-zero and clock signals.

10. The timing apparatus according to claim 8 or 9, characterized in that each of said timing interval generators comprises a flip-flop (54; 64) having an input coupled to receive one of said transfer signals, a stop-restart oscillator (32; 42) having an input coupled to a first output of said flip-flop (54; 64), a counter (34; 44) having an input coupled to an output of said stop-restart oscillator (32; 42) and a delay vernier (36; 46) having an input coupled to an output of said counter (34; 44), an output of said delay vernier (36; 46) producing one of said transfer signals, said output of said stop-restart oscillator (32; 42) producing one of said clock signals, and a second output of said flip-flop (54; 64) producing one of said time-zero signals.

11. The apparatus according to claim 10, characterized by a central processing unit (28) and a data bus coupling said central processing unit to data inputs of said counter (32; 42) and delay vernier (36; 46).

12. The timing apparatus according to any one of the previous claims, characterized in that said signal selection means comprises a multiplexer.

13. The timing apparatus according to any one of the previous claims, characterized by an external synchronizing and delay circuit (26) for triggering said first period generator (12) after a selected delay from receipt of an external trigger signal.

**Patentansprüche**

1. Zeitgebervorrichtung mit ersten und zweiten Zeitlagegeneratoren für die Lieferung von Zeitlagesignalen an einen dritten Zeitlagegenerator, dadurch gekennzeichnet, daß der erste Zeitlagegenerator ein erster Periodengenerator (12) für die Erzeugung eines ersten Satzes von Zeitlagesignalen ist, welcher erste Satz von Zeitlagesignalen ein erstes Nullzeitlagesignal umfaßt mit Flanken, die eine erste Testperiode definieren und auch ein erstes Taktsignal enthalten, welches erste Taktsignal eine erste vorgegebene Zeitspanne nach dem Beginn der ersten Testperiode beginnt,

daß der zweite Zeitlagegenerator ein zweiter Periodengenerator (14) ist für die Erzeugung eines zweiten Satzes von Zeitlagesignalen, welcher zweite Satz von Zeitlagesignalen ein zweites Nullzeitlagesignal umfaßt mit Flanken, die eine zweite Testperiode definieren und auch ein zweites Taktsignal enthalten, welches zweite Taktsignal eine vorgegebene Zeitspanne nach dem Beginn der zweiten Testperiode beginnt und das Signalauswahlmittel (18) an den ersten und den zweiten Periodengenerator angekoppelt sind für die Lieferung ausgewählter Sätze von Zeitlagesignalen aus den ersten und zweiten Sätzen an den dritten Generator (20).

2. Zeitgebevorrichtung nach Anspruch 1, dadurch gekennzeichnet, daß das erste und das zweite Nullzeitlagesignal variabel sind zum Verändern der ersten bzw. zweiten Testperiode.

3. Zeitgebervorrichtung nach Anspruch 1 oder 2, dadurch gekennzeichnet, daß der erste (12) und zweite (14) Periodengenerator ein Hauptperioden- bzw. ein Unterperiodengenerator sind, wobei der zweite Periodengenerator an den ersten Periodengenerator angekoppelt ist, daß die zweite Testperiode innerhalb der ersten Testperiode liegt, und daß die zweite Testperiode eine dritte vorgegebene Zeitspanne nach dem Beginn der ersten Testperiode beginnt.

4. Zeitgebervorrichtung nach Anspruch 3, gekennzeichnet durch einen freilaufenden Periodengenerator (16) für die Erzeugung eines dritten Satzes von Zeitlagesignalen, welcher dritte Satz von Zeitlagesignalen ein freilaufendes Nullzeitlagesignal umfaßt mit Flanken, die eine freilaufende Testperiode definieren und auch ein freilaufendes Taktsignal umfassen, welches freilaufende Taktsignal eine dritte vorgegebene Zeitspanne nach dem Beginn der freilaufenden Testperiode beginnt, wobei das freilaufende Nullzeitlagesignal variabel ist zum Verändern der freilaufenden Testperiode.

5. Zeitgebervorrichtung nach Anspruch 4, dadurch gekennzeichnet, daß der dritte Satz von Zeitlagesignalen ferner ein zweites freilaufendes Nullzeitlagesignal umfaßt und ein zweites freilaufendes Taktsignal, daß der freilaufende Periodengenerator (16) einen ersten freilaufenden Zeitintervallgenerator (160) umfaßt zum Erzeugen des erstgenannten freilaufenden Zeitlagesignals und Taktsignals, und eines ersten freilaufenden Transfersignals, sowie einen zweiten freilaufenden Zeitintervallgenerator (170) für die Erzeugung des genannten zweiten freilaufenden Nullzeitlage- und Taktsignals und eines zweiten freilaufenden Transfersignals, daß der zweite freilaufende Zeitintervallgenerator (170) von dem ersten freilaufenden Transfersignal getriggert wird zum Erzeugen des zweiten freilaufenden Nullzeitlage- und Taktsignals, und daß der erste freilaufende Zeitintervallgenerator (160) durch das genannte zweite freilaufende Transfersignal getriggert wird zum Erzeugen des ersten freilaufenden Nullzeitlage- und Taktsignals.

6. Zeitgebervorrichtung nach einem der Ansprüche 3 bis 5, gekennzeichnet durch programmierbare Verzögerungsmittel (130, 132, 134, 136, 140, 144, 146, 150), angekoppelt zum Empfang des ersten Nullzeitlage- und Taktsignals für die Erzeugung eines verzögerten Synchronisiersignals nach einer programmierbaren Verzögerung nachfolgend dem Empfang des ersten Nullzeitlagesignals, wobei der zweite Periodengenerator (14) an die programmierbaren Verzögerungsmittel (130, 132, 134, 136, 140, 144, 146, 150) angekoppelt ist und ausgebildet ist zum Erzeugen des zweiten Nullzeitlagesignals mit einer festen Verzögerung nach Empfang des verzögerten Synchronisiersignals.

7. Zeitgebervorrichtung nach Anspruch 6, dadurch gekennzeichnet, daß der dritte Zeitlagegenerator (20) ein Tochter-Zeitlagegenerator ist, der erste (222) und zweite (226) Testzeitlagegeneratoren umfaßt für die Erzeugung eines ersten bzw. zweiten Testzeitlagesignals nach der ersten (224) bzw. zweiten (228) Verzögerung, nachfolgend dem Empfang des ersten bzw. zweiten Nullzeitlagesignals, und bei dem die Differenz zwischen der ersten Verzögerung und der Summe der programmierbaren Verzögerung, der festen Verzögerung und der Summe aus der programmierbaren Verzögerung, der festen Verzögerung und der zweiten Verzögerung ein Maß für den Eichfehler des ersten und zweiten Zeitlagegenerators ist.

8. Zeitgebervorrichtung nach einem der vorangehenden Ansprüche, dadurch gekennzeichnet, daß der erste Satz von Zeitlagesignalen ferner ein drittes Nullzeitlagesignal und ein drittes Taktsignal umfaßt, daß der erste Periodengenerator (12) einen ersten Zeitintervallgenerator (30) umfaßt für die Erzeugung des ersten Nullzeitlage- und Taktsignals und eines ersten Transfersignals, und einen dritten Zeitintervallgenerator (40) für die Erzeugung des dritten Nullzeitlage- und Taktsignals und eines dritten Transfersignals, und daß der dritte Zeitintervallgenerator (40) getriggert wird durch das erste Transfersignal zum Erzeugen des dritten Nullzeitlage- und Taktsignals und der erste Zeitintervallgenerator durch das dritte Transfersignal getriggert wird zum Erzeugen des ersten Nullzeitlage- und Taktsignals.

9. Zeitgebervorrichtung nach Anspruch 8, dadurch gekennzeichnet, daß der zweite Satz von Zeitlagesignalen ferner ein viertes Nullzeitlagesignal und viertes Taktsignal umfaßt, daß der zweite Periodengenerator (14) einen zweiten Zeitintervallgenerator (110) umfaßt für die Erzeugung des zweiten Nullzeitlage- und Taktsignals und eines zweiten Transfersignals, sowie einen vierten Zeitintervallgenerator (120) für die Erzeugung des vierten Nullzeitlage- und Taktsignals und eines vierten Transfersignals, daß der vierte Zeitintervallgenerator durch das zweite Transfersignal getriggert wird zum Erzeugen des vierten Nullzeitlage- und Taktsignals, und daß der zweite Zeitintervallgenerator getriggert wird durch das vierte Transfersignal zum Erzeugen des zweiten Nullzeitlage- und Taktsignals.

10. Zeitgebervorrichtung nach Ansprüchen 8 oder 9, dadurch gekennzeichnet, daß jeder der Zeitintervallgeneratoren einer Flip-Flop (54; 64) umfaßt, der mit einem Eingang angekoppelt ist zum Empfang eines der Tranfersignale, einen Stop-Neustart-Oszillator (32; 42) mit einem Eingang angekoppelt an einen ersten Ausgang des Flip-Flop (54; 64), einen Zähler (34; 44), mit einem Eingang an den Ausgang des Stop-Neustart-Oszillators (32; 42) angekoppelt, und eine Verzögerungs-Vernier-Anordnung (36; 46), angekoppelt mit einem Eingang an einen Ausgang des Zählers (34; 44), wobei ein Ausgang der Verzögerungs-Vernier-Anordnung (36; 46) eines der Transfersignale erzeugt, der Ausgang des STop-Neustart-Oszillators (32; 42) eines der Taktsignale erzeugt und ein zweiter Ausgang des Flip-Flop (54; 64) eines der Nullzeitlagesignale erzeugt.

11. Zeitgebervorrichtung nach Anspruch 10, gekennzeichnet durch eine Zentralrechnereinheit (28) und einen Datenbus, der die Zentralrechnereinheit mit den Dateneingängen des Zählers (32; 42) und der Verzögerungs-Vernier-Anordnung (36; 46) gekoppelt.

12. Zeitgebervorrichtung nach einem der vorangehenden Ansprüche, dadurch gekennzeichnet, daß die Signalauswahlmittel einen Multiplexer umfassen.

13. Zeitgebervorrichtung nach einem der vorangehenden Ansprüche, gekennzeichnet, durch eine externe Synchronisier- und Verzögerungsschaltung (26) zum Triggern des ersten Periodengenerators (12) nach einer ausgewählten Verzögerung ab Empfang eines externen Triggersignals.

**Revendications**

1. Dispositif de cadencement comprenant un premier et un deuxième générateur de cadencement pour fournir des signaux de cadencement à un troisième générateur de cadencement caractérisé en ce que

ledit premier générateur de cadencement est un premier générateur de période (12) pour élaborer un premier ensemble de signaux de cadencement, ledit premier ensemble comprenant un premier signal de temps-zéro ayant des fronts définissant une première période de test et comprenant aussi un premier signal d'horloge qui commence un premier intervalle de temps prédéterminé après le début de ladite première période de test;

ledit deuxième générateur de cadencement est un deuxième générateur de période (14) pour élaborer un deuxième ensemble de signaux de cadencement, ledit deuxième ensemble comprenant un deuxième signal de temps-zéro ayant des fronts définissant une deuxième période de test et comprenant aussi un deuxième signal d'horloge qui commence un deuxième intervalle de temps prédéterminé après le début de ladite deuxième période de test; et

des moyens de sélection de signal (18) sont reliés auxdits premier et deuxième générateurs pour fournir audit troisième générateur (20) des signaux sélectionnés parmi lesdits premier et deuxième ensembles de signaux de cadencement.

2. Dispositif de cadencement selon la revendication 1, caractérisé en ce que lesdits premier et deuxième signaux de temps-zéro sont variables pour faire varier lesdites première et deuxième périodes de test.

3. Dispositif de cadencement selon la revendication 1 ou 2, caractérisé en ce que lesdits premier (12) et deuxième (14) générateurs de période sont respectivement des générateurs de période majeur et mineur, ledit deuxième générateur de période est relié audit premier générateur de période, ladite deuxième période de test est incluse dans ladite première période de test et ladite deuxième période de test commence un troisième intervalle de temps prédéterminé après le début de ladite première période de test.

4. Dispositif de cadencement selon la revendication 3, caractérisé par un générateur de période indépendant (16) pour élaborer un troisième ensemble de signaux de cadencement, ledit troisième ensemble comprenant un signal de temps zéro indépendant ayant des fronts définissant une période de test indépendante et comprenant aussi un signal d'horloge indépendant, ledit signal d'horloge indépendant commençant une troisième période de temps déterminée après le début de ladite période de test indépendante, ledit signal de temps zéro indépendant étant variable pour faire varier ladite période de test indépendante.

5. Dispositif de cadencement selon la revendication 4, caractérisé en ce que ledit troisième ensemble de signaux de cadencement comprend de plus un deuxième signal de temps zéro indépendant et un deuxième signal d'horloge indépendant, ledit générateur de période indépendant (16) comprenant un premier générateur d'intervalle de cadencement indépendant (160) pour produire lesdits signaux de temps zéro et d'horloge indépendants mentionnés en premier et un premier signal de transfert indépendant, et un deuxième générateur d'intervalle de cadencement indépendant (170) pour produire lesdits deuxièmes signaux indépendants de temps zéro et d'horloge et un deuxième signal de transfert indépendant, ledit deuxième générateur d'intervalle de cadencement indépendant (170) étant déclenché par ledit premier signal de transfert indépendant pour produire lesdits deuxièmes signaux indépendants de temps zéro et d'horloge, et ledit premier générateur d'intervalle de cadencement indépendant (160) étant déclenché par ledit deuxième signal de transfert indépendant pour produire lesdits premiers signaux indépendants de temps zéro et d'horloge.

6. Dispositif de cadencement selon l'une des revendications 3 à 5, caractérisé par des moyens programmables à retard (130, 132, 134, 136, 140, 144, 146, 150) reliés de façon à recevoir lesdits premiers signaux de temps zéro et d'horloge pour élaborer un signal retardé de synchronisation après un retard programmable suivant la réception dudit premier signal de temps-zéro, ledit deuxième générateur de période (14) étant relié auxdits moyens programmables à retard (130, 132, 134, 136, 140, 144, 146, 150) et étant adapté à élaborer ledit deuxième signal de temps zéro un retard fixe après réception dudit signal retardé de synchronisation.

7. Dispositif de cadencement selon la revendication 6, caractérisé en ce que ledit troisième générateur de cadencement (20) est un générateur esclave qui comprend un premier (222) et un deuxième (226) générateur de cadencement de test pour élaborer des premier et deuxième signaux de cadencement de test après des premier (224) et deuxième (228) retards suivant respectivement la réception desdits premier et deuxième signaux de temps zéro, et dans lequel la différence entre ledit premier retard et la somme dudit retard programmable, dudit retard fixe, et dudit deuxième retard est une mesure d'erreur d'étalonnage pour lesdits premier et deuxième générateurs de cadencement.

8. Dispositif de cadencement selon l'une des revendications précédentes, caractérisé en ce que ledit premier ensemble de signaux de cadencement comprend de plus un troisième signal de temps zéro et un troisième signal d'horloge, ledit premier générateur de période (12) comprenant un premier générateur d'intervalle de cadencement (30) pour produire lesdits premiers signaux de temps zéro et d'horloge et un premier signal de transfert, et un troisième générateur d'intervalle de cadencement (40) pour produire lesdits troisièmes signaux de temps zéro et d'horloge et un troisième signal de transfert, ledit troisième générateur d'intervalle de cadencement (40) étant déclenché par ledit premier signal de transfert pour produire lesdits troisièmes signaux de temps zéro et d'horloge et ledit premier générateur d'intervalle de cadencement étant déclenché par ledit troisième signal de transfert pour produire lesdits premiers signaux de temps zéro et d'horloge.

9. Dispositif de cadencement selon la revendication 8, caractérisé en ce que ledit deuxième ensemble de signaux de cadencement comprend de plus un quatrième signal de temps zéro et un quatrième signal d'horloge, ledit deuxième générateur de période (14) comprenant un deuxième générateur d'intervalle de cadencement (110) pour produire lesdits deuxièmes signaux de temps zéro et d'horloge et un deuxième signal de transfert, et un quatrième générateur d'intervalle de cadencement (120) pour produire lesdits quatrièmes signaux de temps zéro et d'horloge, et un quatrième signal de transfert, ledit quatrième générateur d'intervalle de cadencement étant déclenché par ledit deuxième signal de transfert pour produire lesdits quatrièmes signaux de temps zéro et d'horloge et ledit deuxième générateur d'intervalle de cadencement étant déclenché par ledit quatrième signal de transfert pour produire lesdits deuxièmes signaux de temps zéro et d'horloge.

10. Dispositif de cadencement selon la revendication 8 ou 9, caractérisé en ce que chacun desdits générateurs d'intervalle de cadencement comprend une bascule (54, 64) ayant une entrée connectée pour recevoir l'un desdits signaux de transfert, un oscillateur commandé (32, 42) ayant une entrée reliée à une première sortie de ladite bascule (54, 64), un compteur (34, 44) ayant une entrée reliée à une sortie dudit oscillateur commandé (32, 42) et un retard vernier (36, 46) ayant une entrée reliée à une sortie dudit compteur (34, 44), une sortie dudit retard vernier (36, 46) produisant l'un desdits signaux de transfert, ladite sortie de l'oscillateur commandé (32, 42) produisant l'un desdits signaux d'horloge, et une deuxième sortie de ladite bascule (54, 64) produisant l'un desdits signaux de temps zéro.

11. Dispositif selon la revendication 10, caractérisé par une unité centrale de traitement (28) et un bus de données reliant ladite unité centrale à des entrées de données dudit compteur (32, 42) et dudit retard vernier (36, 46).

12. Dispositif selon l'une des revendications précédentes, caractérisé en ce que lesdits moyens de sélection de signal comprennent un multiplexeur.

13. Dispositif de cadencement selon l'une des revendications précédentes, caractérisé par un circuit externe de synchronisation et de retard (26) pour déclencher ledit premier générateur de période (12) après un retard sélectionné suivant la réception d'un signal externe de déclenchement.

FIG._I.

FIG._2.

FIG._3.

FIG._4.

0 136 207

FIG._5.

FIG._6.

FIG._7.